# EUROPEAN PATENT APPLICATION

(11) **EP 3 048 287 A1**
(43) Date of publication of application: **27.07.2016**
(21) Application number: 14845549.6
(22) Date of filing: 16.09.2014
(51) Int. Cl.: F02F 1/00, C23C 4/06, C23C 28/00, C23C 28/04, F02F 5/00, F16J 9/26, F16J 10/00

(54) **COMBINATION OF CYLINDER BORE AND PISTON RING**

(30) Priority: 20.09.2013 JP 2013195033
(71) Applicant: Kabushiki Kaisha Riken, Tokyo 102-8202 (JP)
(72) Inventor: SHINOHARA, Akio, Kashiwazaki-shi Niigata 945-8555 (JP); MORONUKI, Masaki, Kashiwazaki-shi Niigata 945-8555 (JP)
(74) Representative: Schwabe - Sandmair - Marx
(86) International application number: PCT/JP2014/074443
(87) International publication number: WO 2015/041215

(57) **Abstract**

To provide a combination of a cylinder bore and a piston ring having excellent scuffing resistance and wear resistance with low friction loss even under severe sliding conditions with a high load applied to an engine, by a thermal spraying technique of a cylinder bore enabling the use of a usual die-cast aluminum alloy, a thermally sprayed iron-based coating formed on a piston-ring-sliding surface of a cylinder bore, which has Rpk of less than 0.20 µm in a surface roughness profile, is combined with a hard carbon coating formed on an outer peripheral sliding surface of the piston ring, which has Rpk of less than 0.15 µm in a surface roughness profile, in an internal combustion engine.

## Description

### FIELD OF THE INVENTION

The present invention relates to a combination of a cylinder bore and a piston ring sliding with an inner peripheral surface of the bore in an internal combustion engine, particularly to a combination of a cylinder bore having a thermally sprayed iron-based coating on its inner peripheral sliding surface and a piston ring having a hard carbon coating on its outer peripheral sliding surface.

### BACKGROUND OF THE INVENTION

Improved fuel efficiency has recently been strongly desired on internal engines, mostly automobile engines, so that the research and development of their parts have widely been carried out to make them smaller and lighter with reduced friction loss. For example, attempts are made to use small-specific-gravity aluminum alloys for cylinders, and to form hard carbon coatings having low friction coefficients, which may be called diamond-like carbon (DLC), on piston rings.

Aluminum alloys such as JIS ADC12, etc. are generally characterized by being lightweight with good thermal conductivity. However, aluminum alloys per se are likely subjected to sticking and scuffing in sliding with piston rings. To solve this problem, JP 2005-273654 A discloses engine parts including a cylinder block, which can be mass-produced by a high-pressure die-casting method of a poor-castability aluminum alloy containing as much as 18-22% by weight of silicon (Si), and by controlling a cooling speed near a sliding surface to crystallize primary silicon particles having an average crystal grain size of 12-50 µm on the sliding surface. Relatively hard primary silicon crystal particles contribute to the improvement of scuffing resistance and the suppression of cylinder wear. However, even such aluminum alloy has failed to sufficiently satisfy the requirements of scuffing resistance and wear resistance under severer sliding conditions due to cylinder pressure increase resulting from recent higher power of engines.

An attempt is also made to form a hard carbon coating on a piston ring, to achieve chemical stability and a low friction coefficient to the aluminum alloy. JP 2001-280497 A discloses a combination of a cylinder made of an aluminum alloy having a silicon (Si) content of 7-20% by weight, and a piston ring having a hard coating of diamond-like carbon on an outer peripheral surface, particularly a hard DLC coating having carbides of one or more elements selected from the group consisting of Si, Ti, W, Cr, Mo, Nb and V dispersed therein to have excellent initial conformability, scuffing resistance and wear resistance. However, this hard DLC coating having good initial conformability is actually worn in a short period of time under the above severe sliding conditions.

Aluminum alloy cylinders include those having cast iron liner inserts and those having thermally sprayed iron-based coatings in portions directly sliding with piston rings. Among them, attention is focused to thermal spraying on a cylinder bore, which is expected to provide reduced weight and improved heat transfer performance, thereby providing a lower and more uniform bore temperature. JP 2004-100645 A discloses a cylinder block having a sliding surface with satisfactory friction coefficient and scuffing resistance, contributing to improvement in fuel efficiency and durability, which is obtained by honing thermally sprayed layers on bore inner surfaces to turn the area ratio of pits to 5-14%, and surface roughness (Rk + Rpk) expressed by a sum of core roughness depth Rk and reduced peak height Rpk to 0.9 µm or less on the sliding surfaces. Pits on the sliding surface act as oil pockets, preventing the shortage of a lubricating oil during sliding, and improving scuffing resistance. For example, when an engine is under severe sliding conditions with a high load, however, it has been found that a sufficient oil film is not formed only with the help of oil pockets of pits, resulting in insufficient scuffing resistance. Though the size and number of pits on the sliding surface can be increased, it has also been found that such increases would result in increased oil consumption and an increased friction coefficient due to the burning of a lubricating oil.

Paying attention to oil pockets, JP 2002-235852 A discloses a low-friction sliding member having fine recesses on a smooth sliding surface to have regularly changing depth, with plateau-like projections between recesses. In JP 2002-235852 A, oil pockets are shallow in a stroke center portion with a high sliding speed to prevent increase in friction loss due to the shear loss of an oil film, while oil pockets are deep at stroke ends (top and bottom dead centers of a piston) to avoid the shortage of a lubricating oil, thereby reducing friction loss. However, the formation of a sliding surface having such a structure with the depth of recesses, etc. precisely controlled substantially impractically needs a lot of precise steps.

### OBJECT OF THE INVENTION

An object of the present invention is to provide a combination of a cylinder bore and a piston ring using a thermal spraying technique on a cylinder bore enabling the use of a usual die-cast aluminum alloy, thereby having excellent scuffing resistance and wear resistance with low friction loss even under severe sliding conditions with a high load applied to an engine.

### DISCLOSURE OF THE INVENTION

As a result of intensive research on scuffing resistance in a combination of a cylinder bore having a thermally sprayed iron-based coating with a piston ring having a hard carbon coating, the inventors have found that it is possible to provide a combination of a cylinder bore and a piston ring having excellent scuffing resistance and wear resistance with low friction loss, by controlling reduced peak heights Rpk to predetermined levels in the surface roughness profiles of the thermally sprayed iron-based coating and the hard carbon coating.

Thus, the combination of a cylinder bore and a piston ring according to the present invention is characterized by
the cylinder bore having a thermally sprayed iron-based coating on a surface sliding with the piston ring;
the piston ring having a hard carbon coating on an outer peripheral sliding surface;
a surface roughness profile of the thermally sprayed iron-based coating having Rpk (JIS B 0671-2:2002) of less than 0.20 µm; and
a surface roughness profile of the hard carbon coating having Rpk of less than 0.15 µm.

The surface roughness profile of the thermally sprayed iron-based coating preferably has Rpk of less than 0.15 µm.

The sliding surface of the thermally sprayed iron-based coating preferably has micropits. The area ratio of micropits is preferably 1% or more and less than 10%, more preferably 1% or more and less than 5%. The thermally sprayed iron-based coating is preferably as thick as 100-500 µm.

The hard carbon coating preferably has a hydrogen content of less than 2 atomic %, and Martens' hardness of 17-25 GPa. The hard carbon coating is preferably as thick as 0.5-10 µm.

The piston ring preferably has a primary layer, which is at least one of a chromium nitride layer, a nitrided layer and a chromium plating layer, on a base material. The hard carbon coating preferably has an intermediate layer made of at least one metal selected from the group consisting of Cr, Ti, W and Co, and/or carbide of the metal.

### BRIEF DESCRIPTION OF THE DRAWINGS

Fig. 1 is a scanning electron photomicrograph showing a surface of the thermally sprayed coating of Example 1.
Fig. 2(a) is a schematic view showing a scuffing test method according to the present invention.
Fig. 2(b) is a view showing an elliptical sliding portion generated in a piston ring piece after the scuffing test.

### DESCRIPTION OF THE PREFERRED EMBODIMENTS

The combination of a cylinder bore and a piston ring according to the present invention is characterized by the cylinder bore having a thermally sprayed iron-based coating on an inner peripheral surface; the piston ring having a hard carbon coating on an outer peripheral sliding surface; a surface roughness profile of the thermally sprayed iron-based coating having Rpk (JIS B 0671-2:2002) of less than 0.20 µm, and a surface roughness profile of the hard carbon coating having Rpk of less than 0.15 µm. It is generally said that in the sliding of a piston ring in a cylinder bore, a smoother sliding surface provides a lower friction coefficient. Particularly, scuffing resistance is strongly correlated with reduced peak height Rpk defined in JIS B 0671-2:2002, not with arithmetic mean deviation Ra and ten-point height of roughness profile Rzjis, typical indexes of surface roughness. It has been found that a low friction coefficient and excellent scuffing resistance are achieved by a thermally sprayed iron-based coating having Rpk of less than 0.20 µm, and a hard carbon coating having a Rpk of less than 0.15 µm. When the Rpk of the thermally sprayed iron-based coating and the Rpk of the hard carbon coating are 0.20 µm or more and 0.15 µm or more, respectively, the scuffing resistance is undesirably low, with increased wear. The Rpk of the thermally sprayed iron-based coating is preferably less than 0.15 µm, and the Rpk of the hard carbon coating is preferably less than 0.13 µm.

The combination of a cylinder bore and a piston ring according to the present invention is used in a liner-less cylinder block made of a cast aluminum alloy such as ADC12 defined by JIS, an inner peripheral surface of each bore being directly provided with a thermally sprayed iron-based coating. It is possible to use an aluminum alloy having predetermined heat resistance, strength, elongation, etc. together with good castability without needing a particularly increased amount of silicon (Si). On the other hand, the piston ring is preferably made of silicon-chromium steel (JIS SWOSC-V) or martensitic stainless steel (JIS SUS440B) for compression rings.

Though not particularly restrictive, the thermally sprayed iron-based coating formed on the inner peripheral surface of the cylinder bore is preferably carbon steel at least slightly containing chromium, molybdenum, tungsten, etc., for good scuffing resistance and wear resistance, and a low friction coefficient. For example, JP 2010-275581 A discloses a thermally sprayed iron-based coating comprising by mass 0.3-0.4% of C, 0.2-0.5% of Si, 0.3-1.5% of Mn, and 0.5% or less in total of Cr and/or Mo, the balance being Fe and inevitable impurities. Thermal spraying may be plasma spraying, arc spraying, high-speed flame spraying, etc. Though not particularly restrictive, wire-arc spraying using an iron-based alloy wire is preferable because of economic advantages. In the arc spraying, operation conditions such as current, atomizing gas pressure, nozzle shape, etc. have large influence on the properties of the thermally sprayed coating. Though a thermally sprayed iron-based coating generally contains pores and oxide, its porosity decreases, and the oxide content increases, for example, by increasing the flow rate of an atomizing gas.

Though the inner peripheral surface of the cylinder bore can be finally finished by honing, iron alloy particles and oxide particles having low adhesion are detached, or pores inside are exposed, resulting in micropits having diameters of several micrometers to about 100 µm on the surface. How much thermal spraying particles are detached is influenced by the degree of honing (for example, cutting depth), but it is basically determined by the structure of the thermally sprayed coating because the porosity and the oxide content are determined by thermal spraying conditions as described above. In the combination of a cylinder bore and a piston ring, the micropits acting as oil pockets are particularly important near the top and bottom dead centers of the piston, because boundary lubrication tends to occur there. The area ratio of micropits on a sliding surface of the thermally sprayed coating is preferably 1% or more and less than 10%. Because a larger area ratio of micropits tends to reduce the strength and hardness of the thermally sprayed iron-based coating, the area ratio of micropits is more preferably 1% or more and less than 5%, further preferably 2% or more and less than 5%. The diameters of micropits are preferably in a range of 1-200 µm.

Though not particularly restrictive, the thickness of the thermally sprayed iron-based coating is preferably 100-500 µm as final thickness after honing.

The hard carbon coating formed on an outer peripheral sliding surface of the piston ring likely contains hydrogen due to the production method, but the hydrogen content is preferably less than 2 atomic % in the present invention. Hydrogen contained in the hard carbon coating cuts carbon bonding, resulting in hydrogen terminated bonding. However, in the hard carbon coating containing little hydrogen, an oily agent in the lubricating oil is easily adsorbed to the coating surface to have OH groups attached to carbon atom ends, thereby suppressing real contact to achieve low friction. The hydrogen content is more preferably less than 1 atomic %. To reduce the hydrogen content, a vacuum arc ion plating (VAIP) method using carbon as an evaporation source is preferably used. Why the area ratio of micropits in the thermally sprayed iron-based coating is more preferably 1% or more and less than 5% is mostly due to the fact that an oily agent adsorbed to the hard carbon coating surface acts to reduce friction. The hardness of the hard carbon coating is strongly influenced by the hydrogen content. Taking a low hydrogen content into consideration, the Martens' hardness HMs of the hard carbon coating is preferably 17-25 GPa, more preferably 20-25 GPa. With the hard carbon coating in the above hardness range, metal elements and their carbides and carbonitrides may be contained. Further, hard carbon coatings having different hydrogen contents and metal contents may be laminated to form a hard carbon coating having a laminate structure.

Though not particularly restrictive, the thickness of the hard carbon coating is preferably 0.5-10 µm.

Though the present invention requires the hard carbon coating surface to have Rpk of less than 0.15 µm, a hard carbon coating formed by a vacuum arc ion plating method may have Rpk of 0.15 µm or more, because it likely contains macro-particles. In such a case, the formed hard carbon coating is lapped with a brush or ground to adjust its Rpk to less than 0.15 µm.

Though the hard carbon coating can be formed directly on a piston ring material made of silicon chromium steel or martensitic stainless steel, a base material for an extremely hard carbon coating is preferably as hard as possible with high rigidity. In this sense, the base material preferably has a dense, hard primary layer, which is an ion-plating layer of CrN, etc., a nitrided layer, a chromium plating layer, etc. Also, to secure good adhesion of the hard carbon coating to the base material, it is preferable to form an intermediate layer of at least one metal selected from the group consisting of Cr, Ti, W and Co, and/or their carbides, between the hard carbon coating and the base material or the primary layer.

### Examples 1-4, and Comparative Examples 1 and 2

Using as a thermal spraying material a wire comprising by mass 0.3% of C, 0.2% of Si, 0.3% of Mn, 0.5% of Cr, and 0.2% of Mo, the balance being Fe and inevitable impurities, a thermally sprayed iron-based coating as thick as about 500 µm was formed by an arc spraying method on a blasted surface of an aluminum alloy plate (70 mm x 100 mm x 10 mm) of JIS ADC12 corresponding to a cylinder bore. The thermally sprayed iron-based coatings of Examples 1-4 and Comparative Examples 1 and 2, which were formed under basically the same thermal spraying conditions, were ground in a direction parallel to the 70-mm side, to have different surface textures (Rpk). Also, using each piston ring having a rectangular cross section and a barrel-faced outer peripheral surface [corresponding to nitrided SUS420J2, nominal diameter (d): 90 mm, width (h1): 1.2 mm, and thickness (a1): 3.2 mm], a hard carbon coating as thick as about 1 µm was formed on the outer peripheral surface of the piston ring by vacuum arc ion plating using carbon as a target. Because the hard carbon coatings of Examples 1-4 and Comparative Examples 1 and 2 had Rpk of 0.2-0.3 µm in an as-coated state, they were circumferentially lapped to have different surface textures (Rpk). Incidentally, the thickness of each hard carbon coating was substantially unchanged by lapping.

### [1] Measurement of surface textures (Rpk)

With respect to the thermally sprayed iron-based coatings and the hard carbon coatings of Examples 1-4, and Comparative Examples 1 and 2, their Rpk values were measured by a stylus-type surface roughness tester. The measurement direction was in parallel to the 100-mm side of each thermally sprayed iron-based coating, and along the width direction of the hard carbon coating.

### [2] Measurement of area ratio of micropits and thickness of thermally sprayed iron-based coating

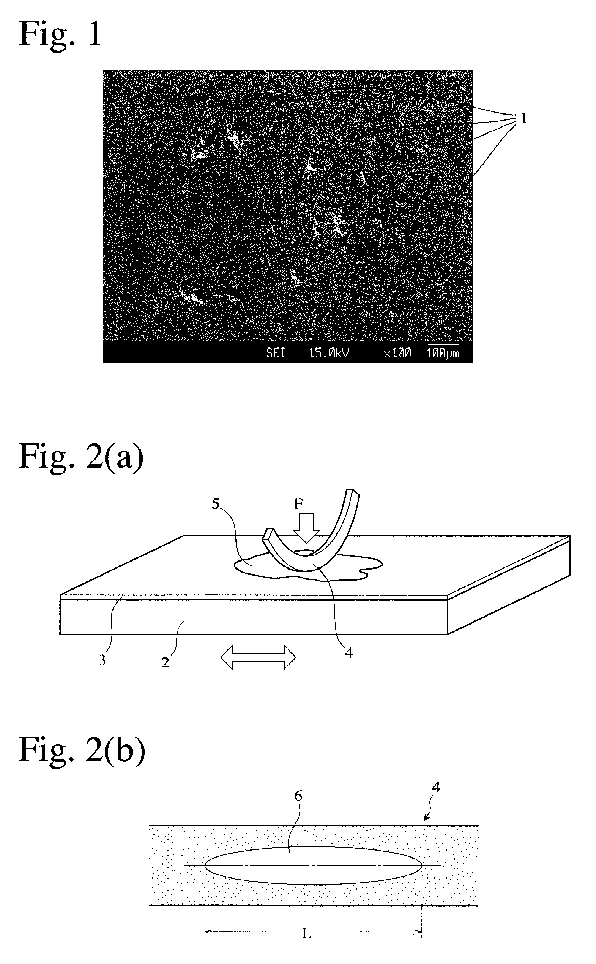

Each aluminum alloy plate (70 mm x 100 mm x 10 mm), on which each thermally sprayed iron-based coating of Examples 1-4 and Comparative Examples 1 and 2 was formed, was cut to Sample A (50 mm x 100 mm x 10 mm) and Sample B (20 mm x 100 mm x 10 mm), and Sample C (10 mm x 10 mm x 10 mm) having a cross-sectional surface on the side of Sample A was cut out of Sample B at a longitudinal center. The thermally sprayed coating surface of Sample C was observed by a scanning electron microscope, and the resultant image was binarized to micropits and a matrix to determine the area ratio of micropits by image analysis. Fig. 1 is a scanning electron photomicrograph showing the thermally sprayed coating surface of Example 1. Micropits 1 as large as several tens of microns to about 100 µm were observed, and the area ratio of micropits was 3.1 %. Measured on a mirror-polished cross-sectional surface of Sample C on the side of Sample A by a scanning electron microscope, the thickness of the thermally sprayed coating was in a range of about 430 µm to about 450 µm in Examples 1-4 and Comparative Examples 1 and 2.

### [3] Measurement of hydrogen content in hard carbon coating

The hydrogen content in the hard carbon coating was measured by Rutherford Backscattering Spectrometry (RBS) and Hydrogen Forward scattering Spectrometry (HFS). The hydrogen content was 1.8 atomic % in Example 1. Because the hard carbon coatings of Examples 2-4 and Comparative Examples 1 and 2 were produced by the same vacuum arc ion plating as in Example 1, it may be presumed that their hydrogen contents were substantially the same as in Example 1.

### [4] Measurement of Martens' hardness of hard carbon coating

The Martens' hardness HMs of each hard carbon coating was measured using a dynamic ultramicro hardness tester using a Berkovich indenter according to ISO 14577-1 (instrumented indentation test), under a test force of 9.8 mN.
A coating surface to be tested was polished with a steel ball having a diameter of 30 mm coated with a paste of diamond particles having an average particle size of 0.25 µm. The Martens' hardness HMs is determined from a load-depth curve. The hard carbon coating of Example 1 had Martens' hardness HMs of 22.6 GPa. Like the hydrogen content, it may also be presumed that the hard carbon coatings of Examples 2-4, and Comparative Examples 1 and 2 had substantially the same Martens' hardness as in Example 1.

### [5] Scuffing test

As shown in Fig. 2(a), the scuffing test was conducted by reciprocally sliding a cut piece 4 (length: about 30 mm) of a piston ring having a hard carbon coating in a width direction relatively on an aluminum alloy plate 2 of Sample A having a thermally sprayed iron-based coating 3, which corresponded to a cylinder bore and fixed to a jig (not shown). In the test, while reciprocally moving the aluminum alloy plate 2 at an amplitude of 3 mm and at 50 Hz, with a vertical load increased at a speed of 100 N/minute, a friction force was measured to determine a scuffing load at which the friction force drastically increased. A lubricating oil 5 used contained 1% by mass of glycerol monooleate (GMO) added to a base oil of poly(α-olefin) (PAO).

### [6] Wearing test

Wearing was measured by a reciprocal sliding test using the same machine as for the scuffing test, under the same conditions as in the scuffing test except for applying a constant vertical load of 100 N for 60 minutes. The wearing of the hard carbon coating 3 was evaluated by a major axis length L of an elliptical sliding portion 6 shown in Fig. 2(b), which was generated in the piston ring piece 4 after the test.

The test results of Examples 1-4, and Comparative Examples 1 and 2 except for the thickness of each coating, and the hydrogen content and Martens' hardness of each hard carbon coating are shown in Table 1 below. The scuffing load in the scuffing test and the wear in the wearing test are shown by relative values, assuming that they were 1 in Comparative Example 1.

**Table 1**

| No. | Cylinder Bore (Thermally Sprayed Iron-Based Coating) | | Piston Ring (Hard Carbon Coating) | Scuffing Load* | Wear of Piston Ring* |
|---|---|---|---|---|---|
| | Rpk (µm) | Area Ratio of Micropits (%) | Rpk (µm) | | |
| Example 1 | 0.12 | 3.1 | 0.12 | 1.51 | 0.61 |
| Example 2 | 0.10 | 2.9 | 0.09 | 1.65 | 0.53 |
| Example 3 | 0.14 | 3.5 | 0.13 | 1.44 | 0.64 |
| Example 4 | 0.16 | 4.2 | 0.14 | 1.29 | 0.77 |
| Com. Ex. 1 | 0.11 | 2.7 | 0.17 | 1.0 | 1.0 |
| Com. Ex. 2 | 0.21 | 4.7 | 0.14 | 1.1 | 0.95 |

| | | | | | |
|---|---|---|---|---|---|
| Note: * Relative value. | | | | | |

When the thermally sprayed iron-based coating had Rpk of 0.20 µm or more, or when the hard carbon coating had Rpk of 0.15 µm or more, there was relatively large wear in the hard carbon coating with a low scuffing load, but when the thermally sprayed iron-based coating had Rpk of less than 0.20 µm, and when the hard carbon coating had Rpk of less than 0.15 µm, the scuffing load was remarkably improved with reduced wear.

### Examples 5-7

Aluminum alloy plates corresponding to cylinder bores in Examples 5-7 were produced in the same manner as in Example 1, except for changing the thermal spraying conditions of thermally sprayed iron-based coatings to have different area ratios of micropits. A piston ring combined with each of these aluminum alloy plates had the same hard carbon coating as in Example 1. With respect to the thermally sprayed iron-based coatings of Examples 5-7, Rpk and the area ratio of micropits were measured in the same manner as in Example 1, and the same scuffing test and wearing test as in Example 1 were conducted.

### Example 8

The piston ring of Example 8 was produced in the same manner as in Example 1, except for forming a CrN primary layer as thick as about 30 µm, and then forming an intermediate layer of metal Cr as thick as about 0.5 µm, and a hard carbon coating as thick as about 1.5 µm by vacuum arc ion plating, on a piston ring made of SUS440B. Measurement revealed that the hard carbon coating had Rpk of 0.14 µm, a hydrogen content of 0.7 atomic %, and Martens' hardness of 24.1 GPa. An aluminum alloy plate combined with the piston ring of Example 8 was provided with the same thermally sprayed iron-based coating as in Example 1, and subjected to the scuffing test and the wearing test.

### Example 9

An aluminum alloy plate corresponding to a cylinder bore in Example 9 was produced in the same manner as in Example 1, except for changing the thermal spraying conditions of a thermally sprayed iron-based coating to have as small an area ratio of micropits as possible. Measurement revealed that the thermally sprayed iron-based coating of Example 9 had Rpk of 0.05, and the area ratio of micropits of 0.9%. A piston ring combined was provided with the same hard carbon coating as in Example 1, and subjected to the scuffing test and the wearing test. The results are shown in Table 2 together with those of Examples 5-8.

**Table 2**

| No. | Cylinder Bore (Thermally Sprayed Iron-Based Coating) | | Piston Ring (Hard Carbon Coating) | Scuffing Load* | Wear of Piston Ring* |
|---|---|---|---|---|---|
| | Rpk (µm) | Area Ratio of Micropits (%) | Rpk (µm) | | |
| Example 5 | 0.12 | 5.6 | 0.12 | 1.34 | 0.61 |
| Example 6 | 0.10 | 9.2 | 0.12 | 1.32 | 0.69 |
| Example 7 | 0.14 | 10.6 | 0.12 | 1.25 | 0.64 |
| Example 8 | 0.12 | 3.1 | 0.14 | 1.58 | 0.58 |
| Example 9 | 0.05 | 0.9 | 0.12 | 1.09 | 0.63 |

| | | | | | |
|---|---|---|---|---|---|
| Note: * Relative value. | | | | | |

### EFFECTS OF THE INVENTION

Because an aluminum-alloy-made cylinder block is basically used in the combination of a cylinder bore and a piston ring according to the present invention, it contributes to weight reduction. Also, because a thermally sprayed iron-based coating is formed on a sliding surface of a cylinder bore by thermal spraying, not only high-silicon aluminum alloys but also usual die-cast aluminum alloys such as JIS ADC12, etc. can be used. Of course, expensive apparatuses for high-pressure die-casting are not needed. As compared with a cast aluminum alloy cylinder with a cast iron liner insert, thermal spraying in cylinder bores makes it possible to provide cooling paths between the cylinder bores to turn them to independent bores, thereby lowering the temperature of the entire bores and drastically improving their uniformity. By reducing Rpk to a predetermined level in both surface roughness profiles of the thermally sprayed iron-based coating in the cylinder bore and the hard carbon coating on the piston ring, which is a feature of the present invention, a friction coefficient can be reduced during sliding, contributing to the reduction of friction loss. Particularly, by forming a hard carbon coating having a hydrogen content of less than 2% on the piston ring, excellent scuffing resistance can be obtained even when the thermally sprayed iron-based coating has a small area ratio of micropits. Thus, even under severe sliding conditions with a high load applied to an engine, it is possible to provide a combination of a cylinder bore and a piston ring having excellent scuffing resistance and wear resistance with low friction loss.

## Claims

1. A combination of a cylinder bore and a piston ring in an internal combustion engine,
said cylinder bore having a thermally sprayed iron-based coating on a surface sliding with the piston ring;
said piston ring having a hard carbon coating on an outer peripheral sliding surface;
a surface roughness profile of said thermally sprayed iron-based coating having Rpk (JIS B 0671-2:2002) of less than 0.20 µm; and
a surface roughness profile of said hard carbon coating having Rpk of less than 0.15 µm.

2. The combination of a cylinder bore and a piston ring according to claim 1, wherein the surface roughness profile of said thermally sprayed iron-based coating has Rpk of less than 0.15 µm.

3. The combination of a cylinder bore and a piston ring according to claim 1 or 2, wherein said sliding surface of said thermally sprayed iron-based coating has micropits, whose area ratio is 1% or more and less than 10%.

4. The combination of a cylinder bore and a piston ring according to claim 3, wherein the area ratio of said micropits is 1% or more and less than 5%.

5. The combination of a cylinder bore and a piston ring according to any one of claims 1-4, wherein said thermally sprayed iron-based coating is as thick as 100-500 µm.

6. The combination of a cylinder bore and a piston ring according to any one of claims 1-5, wherein said hard carbon coating has a hydrogen content of less than 2 atomic %.

7. The combination of a cylinder bore and a piston ring according to claim 6, wherein said hard carbon coating has Martens' hardness of 17-25 GPa.

8. The combination of a cylinder bore and a piston ring according to any one of claims 1-7, wherein said hard carbon coating is as thick as 0.5-10 µm.

9. The combination of a cylinder bore and a piston ring according to any one of claims 1-8, wherein said piston ring has a primary layer, which is at least one of a chromium nitride layer, a nitrided layer and a chromium plating layer, on a substrate.

10. The combination of a cylinder bore and a piston ring according to any one of claims 1-9, wherein said hard carbon coating has an intermediate layer made of at least one metal selected from the group consisting of Cr, Ti, W and Co, and/or carbide of said metal.
